# EUROPEAN PATENT SPECIFICATION

(11) **EP 0 422 828 B1**
(45) Date of publication and mention of the grant of the patent: **16.03.1994**
(21) Application number: 90310838.9
(22) Date of filing: 03.10.1990
(51) Int. Cl.: H05K 13/00

(54) **Improved film carrier**
Folienträger
Support amélioré de feuilles

(30) Priority: 09.10.1989 JP 263408/89
(43) Date of publication of application: 17.04.1991
(73) Proprietor: CHISSO CORPORATION, Osaka (JP)
(72) Inventor: Shouji, Hideaki, Ichiharashi, Chibaken (JP); Takahashi, Akio, Chibashi, Chibaken (JP); Furukawa, Hidenori, Ichiharashi, Chibaken (JP); Wada, Masami, Yokosukashi, Kanagawaken (JP)
(74) Representative: Ruffles, Graham Keith

(56) References cited:
- EP-A- 0 066 339
- EP-A- 0 112 177
- EP-A- 0 337 775
- EP-B- 0 022 279
- EP-B- 0 042 987
- JP-A-60 240 151

## Description

The present invention relates to a film carrier comprising an electrically insulating organic film tape having one or more patterned electrical conductors adhered thereto; which carrier can be used, folded in one or more places, in high-density mounting after having been fitted with a large scale integrated circuit (LSI) device.

Thinner and more miniaturized models of electronic appliances (such as electronic calculators, electronic pocketbooks and liquid crystal television sets) are in increasing demand on the general market, and, as a result a problem for manufacturers and suppliers of such electronic appliances is how to mount electronic components therein at as high a density and in as a high yield as possible.

Against this background, a tape automated bonding system (TAB system) using a film carrier is employed in the mounting of large scale integrated circuit (LSI) devices into electronic appliances such as electronic calculators, electronic pocketbooks and liquid crystal television sets.

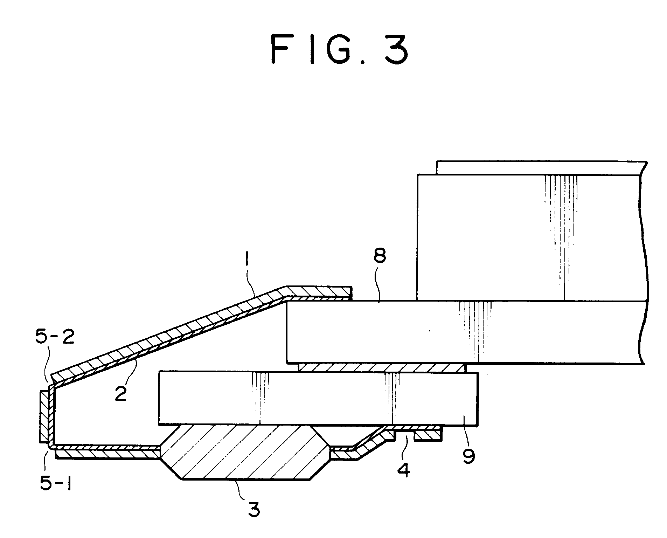

Further, when mounting a liquid crystal display (LCD) driver and the like, a mounting system using a film carrier which is folded in one or more places is employed with the aim of producing as thin and as compact mounting as possible. This is illustrated, for example in Fig. 3 of the accompanying drawings.

In Fig. 3, numeral 1 refers to an organic insulating film made of a polyimide, a polyester or the like; numeral 2 to a lead of a patterned electrical conductor formed from a conductive metal foil (such as a copper foil or a copper-based alloy foil) by photolithographic technology; numeral 3 to a moulded portion wherein a large scale integrated circuit (LSI) device is sealed with a resin; numeral 4 to an outer lead hole; numerals 5-1 and 5-2 to slits for folding (hereinafter often referred to as "folding slits"); numeral 8 to a liquid crystal panel; and numeral 9 to a panel circuit board.

In this case, leads of the film carrier on the side of which the lead width and the lead pitch are relatively larger are soldered to the terminal area of the panel circuit board 9, while the leads of the film carrier on the side on which the lead width and the lead pitch are relatively smaller are bonded to the finely pitched connecting terminals on the liquid crystal panel 8 under heat and pressure by using an anisotropic conductive film or the like therebetween.

The film carrier is folded in one or more places thereof, as shown in Fig. 3, to produce as thin and as compact mounting as possible.

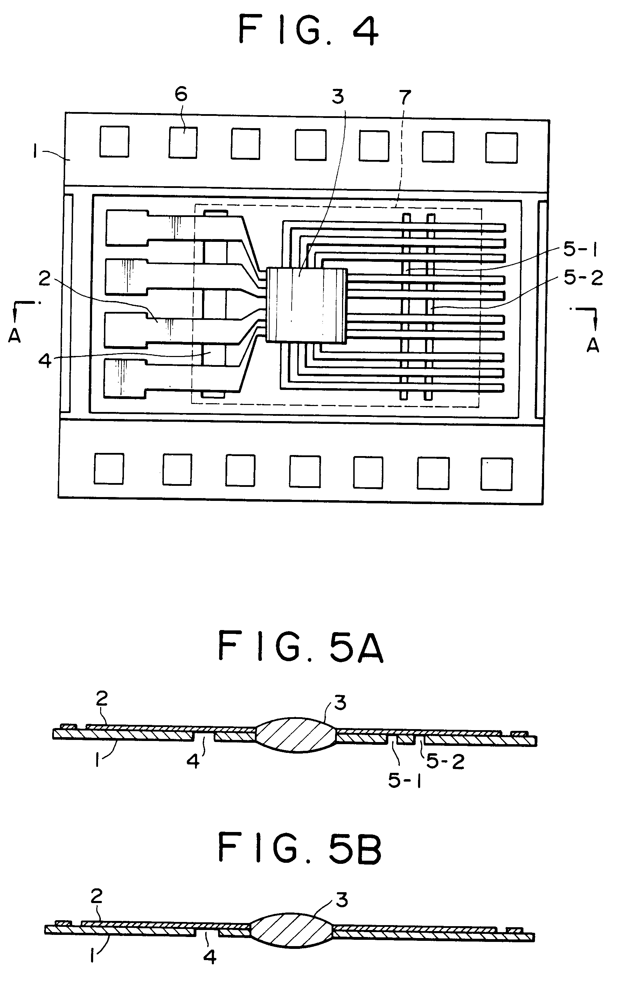

Fig. 4 of the accompanying drawings shows the structure of a conventional film carrier which is used, folded in one or more places, in mounting; while Fig. 5A is a cross section along line A-A of Fig. 4.

In Figures 4 and 5A, numeral 1 refers to an organic insulating film made of a polyimide, a polyester or the like; numeral 2 to a patterned electrical conductor formed from a foil of an electrical conductor metal (such as copper or a copper-based alloy) by photolithographic technology; numeral 3 to a moulded portion wherein a large scale integrated circuit (LSI) device is sealed with a resin; numeral 4 to an outer lead hole; numerals 5-1 and 5-2 to folding slits; and numeral 6 to sprocket holes. This type of film carrier is used in mounting after having been cut along a cut line 7 to be separated from the organic insulating film.

Besides the above-mentioned type of film carrier, there is another conventional type of film carrier which is used folded in one or more places in mounting, but has no folding slits 5-1 and 5-1, as shown in Fig. 5B.

Where the lead width and the lead pitch are very much reduced, in keeping with the trend toward finer lead pitches, however, a film carrier as shown in Fig. 5A involves the grave problem that the yield thereof is lowered because disconnections, short circuits, etc. of leads are liable to occur in the course of production of film carriers, fitting of large scale integrated circuit (LSI) devices onto the film carriers, and folding of the film carriers in mounting.

On the other hand, a film carrier as shown in Fig. 5B involves grave problems in that: (1) difficulty is encountered in mounting at a high density because the folding places thereof are not fixed) and (2) that residual stresses are generated in the folded places of the film carrier in mounting thereof to reduce the long-term reliability of connection portions.

The present invention has been made in view of the foregoing problems of the prior art. Thus, an object of the present invention is to provide a film carrier comprising an organic insulating film and a patterned electrical conductor adhered to the organic insulating film tape, wherein the foregoing problems of the prior art arising in keeping with the trend toward finer lead pitches can be solved by reducing the thickness of the organic insulating film tape in part(s) of the conductor pattern area thereof as compared with the thickness of the organic insulating film in the area thereof than the above-mentioned part(s) surrounded thereby.

More specifically, in accordance with the present invention, there is provided a film carrier comprising an organic insulating film tape having a patterned conductor adhered thereto, which carrier is provided with one or more folded places in one or more parts of the conductor pattern area, where the organic insulating film tape is smaller in thickness than in the area thereof other than the above-mentioned one or more parts surrounded thereby.

In the above-mentioned film carrier, the part(s) of the organic insulating film tape, smaller in thickness than the area thereof other than the above-mentioned part(s), is preferably in rectangular form, disposed perpendicular to or parallel with the longer direction of the film tape.

The reduced thickness of the organic insulating film tape is suitably 4/5 to 1/10 of the larger thickness of the organic insulating film in the area other than the above-mentioned reduced thickness part(s).

The number of folding places is preferably 1 to 5.

In this specification, reference is made to the accompanying drawings, in which:-
Fig. 1 is a plan view of an example of a film carrier of the present invention;
Fig. 2 is a cross-section along line A-A of Fig. 1;
Fig. 3 is a cross-sectional view of an example of conventional film carrier which is used in a state of being folded in one or more places in mounting of the film carrier fitted with an LCD driver;
Fig. 4 is a plan view of another example of conventional film carrier which is used in a state of being folded in one or more places thereof in mounting thereof;
Fig. 5A is a cross-section along line A-A of Fig. 4; and
Fig. 5B is a cross-sectional view of a further example of conventional film carrier similar to the film carrier of Fig. 5A but different therefrom in the absence of folding slits as provided in the film carrier of Fig. 5A.

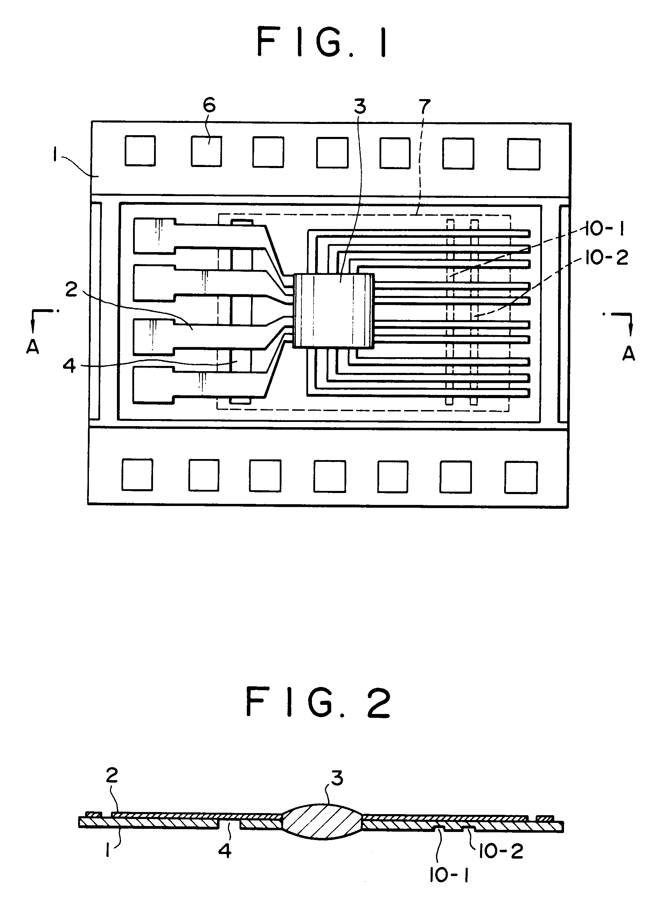

Fig. 1 is a plan view of an example of a film carrier of the present invention, while Fig. 2 is a cross-section along line A-A of Fig. 1.

In the Figures 1 and 2, numeral 1 refers to an organic insulating film made of a polyimide, a polyester or the like, which may be adhered to a copper foil, a copper-based alloy foil or the like; numeral 2 to a patterned electrical conductor formed from a foil of an electrical conductor metal (such as copper or a copper-based alloy) by photolithographic technology; numeral 3 to a moulded portion wherein a large scale integrated circuit (LSI) device is sealed with a resin; numeral 4 to an outer lead hole; and numeral 6 to sprocket holes. This film carrier is used in mounting thereof after having been cut along cut line 7 to be separated from the organic insulating film.

The parts 10-1 and 10-2 of the organic insulating film of the film carrier, which correspond to folding slits in the conventional film carrier, are smaller in film thickness than the area of the organic insulating film other than parts 10-1 and 10-2, to allow the film carrier to be folded.

Methods of reducing the thickness of the organic insulating film in the folding place(s) include processing methods such as (1) mechanical cutting, (2) laser cutting, (3) chemical etching, and (4) plasma etching.

In the process for producing a film carrier which comprises the step of punching a laminate tape comprising a foil of an electrical conductor metal and an organic insulating film applied thereon by a coating method to form sprocket holes, the step of mechanically cutting the tape with a cutting machine or the like to form device holes, outer lead holes, folding slits, etc., and the step of forming electrical conductor patterns by photolithographic technology (this process is disclosed in Japanese Patent Application No. 317,136/1988), the amount of cutting in the thickness-wise direction of the film with the above-mentioned cutting machine only in the case of the folding slits (in the step of forming device holes, outer lead holes and folding slits) is decreased so as to provide a smaller thickness in the parts of the film corresponding to the folding slits than the original thickness of the organic insulating film, whereby the film carrier of the present invention can be produced.

While the mechanical cutting method is employed in the foregoing example, substantially the same processing (partial removal of the organic insulating film in the thickness-wise direction thereof) as described above can be achieved by any one of the aforementioned processing methods. Additionally, the processing step may be carried out in any stage between the course of production of the film carrier and a step just before mounting thereof. Thus, the point of time when the processing is done should be construed as a factor in limiting the scope of the present invention.

As described above in detail, the reduced thickness of the organic insulating film in part(s) of the electrical conductor pattern area thereof than that in the area thereof other than the above-mentioned parts surrounded thereby provides the film carrier of the present invention with the following effects.
(a) Disconnection, short circuit, etc. of the leads do not occur in the course of producing film carriers, in the step of fitting the film carriers with large scale integrated circuit (LSI) devices, and in other steps to attain an increase in the yield.
(b) Disconnection, short circuit, etc. of the leads do not occur in the course of mounting of film carriers to attain an increase in the yield in the bonding step.
(c) Connection in the course of high-density mounting of film carriers can be easily done with high precision even in the case where the terminals on the film carriers to be used for connection are finely pitched.
(d) The residual stresses in the portions of the film carriers where the film carriers are folded in high-density mounting thereof are so small as to improve the long-term reliability of the connected portions.

## Claims

1. A film carrier comprising an organic insulating film tape (1) and a patterned conductor pattern (2) adhered to said organic insulating film tape, which carrier is provided with one or more folding places (10-1, 10-2) in one or more parts of the conductor pattern area thereof where said organic insulating film tape is smaller in thickness than in the area thereof other than said one or more parts.

2. A film carrier as claimed in claim 1, wherein said one or more parts are in rectangular form, disposed perpendicular to or parallel with the longer direction of said organic insulating film tape.

3. An improved film carrier as claimed in claim 1 or claim 2, wherein the reduced thickness of said organic insulating film tape in said one or more parts is 4/5 to 1/10 of the thickness of the organic insulating film in the areas other than said one or more parts.

## Patentansprüche

1. Filmträger, der ein organisches isolierendes Filmband (1) mit einem daran angeklebten strukturierten Leiterbild umfaßt, wobei der Träger mit einer oder mehreren gefalteten Stellen (10-1, 10-2) an einem oder mehreren Teilen des Leiterbildbereiches desselben versehen ist, wo das organische, isolierende Filmband dünner ist als in dem außerhalb der oben erwähnten einen oder mehreren Teile liegenden Bereich.

2. Filmträger nach Anspruch 1, wobei der eine oder die mehreren Teile rechteckige Form haben und rechtwinklig oder parallel zur Längsrichtung des organischen, isolierenden Filmbandes angeordnet sind.

3. Verbesserter Filmträger nach Anspruch 1 oder Anspruch 2, wobei die verringerte Dicke des organischen, isolierenden Filmbandes an dem einen oder den mehreren Teilen 4/5 bis 1/10 der Dicke des organischen, isolierenden Films in den Bereichen beträgt, die außerhalb des einen oder der mehreren Teile liegen.

## Revendications

1. Support de feuille comprenant une bande de feuille organique isolante (1) et un motif de conducteur profilé (2) collé à ladite bande de feuille organique isolante, ledit support comportant un ou plusieurs endroits de pliage (10-1, 10-2) dans une ou plusieurs parties de la zone à conducteur profilé de celui-ci où ladite bande de feuille organique isolante a une plus faible épaisseur que dans la zone de celle-ci autre que ladite ou lesdites une ou plusieurs partie(s).

2. Support de feuille selon la revendication 1, dans lequel ladite ou lesdites une ou plusieurs parties(s) ont une forme rectangulaire et sont disposées perpendiculairement ou parallèlement à la direction longitudinale de ladite bande de feuille organique isolante.

3. Support de feuille amélioré selon la revendication 1 ou 2, dans lequel l'épaisseur réduite de ladite bande de feuille organique isolante dans ladite ou lesdites une ou plusieurs partie(s) est comprise entre 4/5 et 1/10 épaisseur de la feuille organique isolante dans les zones autres que ladite ou lesdites une ou plusieurs partie(s).
